Europäisches Patentamt

European Patent Office

Office européen des brevets

(11) Publication number: **0 331 908**
A1

## EUROPEAN PATENT APPLICATION

(21) Application number: 89101915.0

(22) Date of filing: 03.02.89

(51) Int. Cl.⁴: **H01L 21/60 , H01L 21/90 ,
H01L 23/52**

(30) Priority: 07.03.88 US 164692

(43) Date of publication of application:
13.09.89 Bulletin 89/37

(84) Designated Contracting States:
DE FR GB

(71) Applicant: International Business Machines
Corporation
Old Orchard Road
Armonk, N.Y. 10504(US)

(72) Inventor: Farrar, Paul Alden
17 Yandow Drive South Burlington
Vermont 05403(US)
Inventor: Geffken, Robert Michael
88 Gosse Court Burlington
Vermont 05401(US)

(74) Representative: Mönig, Anton, Dipl.-Ing.
IBM Deutschland GmbH Schönaicher
Strasse 220
D-7030 Böblingen(DE)

(54) **Method for forming high density, ohmic contact multi-level metallurgy for semiconductor devices.**

(57) Multilevel interconnections for high density integrated circuit devices are described which have reliable low resistivity contacts suitable for sub-micron semiconductor technologies including NMOS, CMOS and biFET. First level interconnections are achieved by the use of a multilayer metallurgical structure comprising a first layer of titanium and a second layer of aluminum containing 3.5 to 10 percent copper and an unexpectedly high content of silicon (2.5 to 8.0 percent). Second and subsequent levels of interconnection are provided using metallurgy including a first layer of titanium and a second layer of aluminum-copper. Prior to deposition of the second level conductors, multiple cleaning steps in oxygen plasma and hot aqueous chromic-phosphoric acid baths ensure that extremely low resistance contacts are formed in sub-micron contact regions.

FIG.8

# METHOD FOR FORMING HIGH DENSITY, OHMIC CONTACT MULTI-LEVEL METALLURGY FOR SEMICON-DUCTOR DEVICES

This invention relates to methods of forming interconnecting metallurgy on semiconductor substrates, and more particularly to methods for providing low resistivity contacts between layers and to the substrate, high resistance to electromigration failure, and low defect densities suitable for sub-micron VLSI technologies.

Aluminum-based metallurgy has long been the choice for the interconnection of silicon semiconductor device devices, particularly in a manufacturing environment. Because of its relativity low cost, ease of handling, electrical characteristics and availability, aluminum has perhaps been the subject of more research and development than any other technological feature in semiconductor processing. Successfull implementation of a particular metallurgy in a manufacturing environment requires that several diverse criteria be met. The particular metallurgical system must be capable of providing ohmic contact to semiconductor substrates of different conductivity types and, in multilevel systems, between layers of metallurgy. The system must have suitably low resistivity along extensive lateral dimensions despite its extremely small vertical dimension. It must capable of being formed with a minimum of processing steps in order to maintain high yields and to keep costs low. Although aluminum has met these requirements in the past, the advent of sub-micron lithography has seemingly pushed aluminum to its limits.

Even in its infancy, aluminum has been plagued with difficulties. One of the earliest problems faced by semiconductor process engineers was caused by the fact that silicon has significant solubility in aluminum at temperatures just below the silicon-aluminum eutectic temperature. Such temperatures are required during semiconductor processing. When aluminum and silicon are in contact, silicon diffuses into the aluminum at normal processing temperatures to the extent that the aluminum will penetrate shallow diffused regions causing shorting of the conductor to the substrate. Kuiper, in his US-A-3 382 568, recognized that if a quantity of silicon was present in the aluminum which just exceeded the solubility of silicon in aluminum the driving force for the solid state diffusion of silicon could be reduced to zero. He also recognized, see US-A-3 413 157, that an excess of silicon present in the aluminum would cause silicon to precipitate from the solid solution and form an epitaxial layer of aluminum doped silicon at the interface of the silicon substrate and the metal. Silicon available for forming an epitaxial layer will be extracted from the aluminum from a distance up to several microns from the specific contact area.

The presence of such epitaxial silicon in ohmic contact metallurgy is undesirable due the high resistivity of the epitaxial layer. Therefore, it has been necessary to carefully control the percent of silicon in aluminum. Several techniques have been proposed for providing the necessary silicon content in aluminum. Kuiper proposed the use of a silicon-aluminum alloy and the use of a multilayer or sandwich structure of aluminum/silicon/aluminum. Greer, in his US-A-3 881 971, taught a method of depositing a silicon layer over the aluminum layer which provided the added benefit of reducing the oxidation of the upper surface of aluminum after the deposition process.

Another early recognized problem presented by the use of aluminum metallurgy was that of electro-migration, in which the passage of electrical current could cause the physical migration of aluminum within a conductor resulting in electrical failure after a period of time due to physical discontinuities in the conductor. Ames et al, in their US-A-3 725 389, found that the addition of small quantities of foreign material, particularly copper, to aluminum would substantially increase the electromigration resistance of aluminum. Percentages conventionally used for this purpose are in the range of 0.1 to 10 percent by weight.

Aluminum metallurgy was also found to be subject to the formation of "hillocks" or clusters of aluminum which increase the local thickness of conductors to such an extent that overlying layers of passivation material were ruptured. Over the years it has been verified that various additives, including silicon, copper and refractory metals such as titanium, reduce the tendency of aluminum to form hillocks.

As semiconductor dimensions were continually reduced, new problems arose. Because of the tendency of both silicon and aluminum to form natural nonconductive oxides when exposed to ambient atmospheres, resistivity between layers was seen to increase when micron and sub-micron dimensions for contact vias became practical. Although oxides having a thickness of about 3 nm (30 Angstroms) were previously present in contact areas, the density of defects or pinholes in the oxides allowed reasonably low resistance contact to be made in the presence of these oxide layers. As contact vias were reduced in size, the level of defects proved to be too low to ensure reliable ohmic contact to under lying layers. Lands et al, in their US-A-3 499 213, found that a thin layer of titanium under the aluminum had the ability to form an insoluble ohmic barrier between aluminum and silicon. Although initially believed to be an alternative to the addition of silicon to aluminum to prevent aluminum penetration in silicon substrates, the presence of a titanium layer was later found to have additional beneficial properties. Titanium has an affinity for reacting with the oxides of both silicon and aluminum and, thus, could reduce the resistance caused by natural oxides and would also provide increased adhesion between aluminum and passivation oxides used to separate and isolate metal layers in multilayer structures. Drake et al, in US-A-4 121 241, and Schilling, in US-A-4 107 726, taught, respectively, that multilevel metallurgy structures including multiple layers of Titanium/tungsten or refractory metals (particularly titanium) and aluminum could provide ohmic contact between both silicon substrates and upper metal layers. The deposition process described included the sputtering of the underlying refractory layer and evaporation of aluminum followed by the subtractive wet chemical etching of the composite layers. Prior to sputtering of the refractory metal an argon reverse sputtering step was used to remove any undesirable oxides. Inayoshi, GB-A-1 596 907, teaches a similar multilevel metallurgy process in which titanium and aluminum are both evaporated prior to being etched.

In addition to improvements in the electrical conductivity characteristics in semiconductor interconnection technology, advancements have been made in improving the isolation or ßassivation of metallurgy. For example, the traditional use of glassy inorganic passivation layers, such as silicon dioxide, is subject to physical cracking due to differences in the thermal expansion characteristics of metallurgy and passivation layers. Epifano et al, in US-A-3 700 497, recognized the value of substituting an organic polymer layer for glassy oxides. Epifano taught that glassy polymers such as polyimides could be used in place of inorganic oxides in semiconductor interconnection systems. Various improvements to the use of polyimide passivation have been made including that of Bahrle et al, in US-A-4 152 195, in which polyamide acid precursors to polyimide are applied and only partially cured before etching.

Because of the constant need to provide the smallest achievable dimensions in defining metallurgical lines, wet chemical etching can be supplanted in many instances by "lift-off" technology in which the traditional deposition and etch processing sequence is replaced by a stenciling technique. In lift-off processing, the metallurgy-defining mask is applied prior to deposition of the conductive layers and the mask and overlying layers are stripped off of the substrate to leave the desired metallurgy. An example of the use of lift-off processing is found in US-A-4 423 547. Lift-off techniques can be further enhanced by the use of "image reversal" photo-lithographic techniques described in US-A-4 104 070. Here the metallurgical pattern mask is defined in the same manner as in conventional processing, i.e. the mask pattern is defined to represent the actual lines desired, but the processing of the photoresist is such that the pattern formed on the semiconductor substrate is complementary to that pattern. US-A-4 423 547, is representative of lift-off technology in a multilevel metallurgy technology. Lift-off processing has a significant advantage over subtractive etching in that materials such as titanium, a material difficult to etch chemically, are defined by the lift-off mask and require no etching after deposition.

Another feature of the US-A-4 423 547 is the use of both silicon nitride and polyimide as passivation layers between the first and second aluminum levels and polyimide to passivate the second level.

While there exist numerous references directed to techniques for implementation and analysis of aluminum-based metallurgy systems, it is believed that the following are representative. Previously cited GB-A-1 596 907 teaches the formation of multiple level metallurgy in which a first layer of platinum, gold, copper, titanium, chromium, molybdenum, or tungsten of up to 100 nm is evaporated prior to a second layer of up to 1500 nm aluminum on a lift-off photoresist mask layer. Reaction between the thin first layer and aluminum and between the same layer and both crystalline and polycrystalline silicon was believed to provide adequate ohmic contact between layers. Dielectric isolation between metal layers can be inorganic such as phosphosilicate glass or organic such as polyimide. Vias, allowing interconnection between layers, are described as being between 4 and 5 $\mu m^2$ (4 and 5 microns square).

The article, "A New Application of Al-Si Films Coated with TiSi2 in VLSI Multi-Level Interconnections," by Shima et al, Extended Abstracts of the 15th Conference on Solid State Devices and Materials, Tokyo, 1983, pp. 233-236, teaches that sputter deposited aluminum films containing 1 percent silicon when overlaid with sputter deposited TiSi2 provided a significant improvement in electromigration lifetime and also in a lack of hillock growth. The authors concluded that metallurgy consisting of Al-Si-Cu would be not suitable to provide multi-level interconnections due to significant hillock growth.

The article, "Layered and Homogeneous Films of Aluminum and Aluminum/Silicon with Titanium and Tungsten for Multilevel Interconnects," By Gardner et al, IEEE Tr. on Electron Devices, Vol. ED-32, No. 2, February 1985, pp. 174-183, (see also US-A-4 673 623 to several of the same authors) describes various electrical and physical characteristics of metal interconnection technology segments, i.e. structures described are not part of an integrated circuit environment including vias for interconnection between layers. Structures described include: a single under-layer of titanium or tungsten having a thickness of 20 to 50 nm overlaid with 900 nm aluminum containing 1 percent silicon, a similar structure with the Ti or W layer on top of the Al-Si, multilayer films consisting of alternating thinner layers of Ti or W and AL-Si, and homogeneous layers of Ti or W, Al and Si. All films were sputter deposited and contained 1 percent Si. The maximum atomic percent of Titanium in homogeneous films without producing a rough surface was found to be 4 percent. Maximum thickness of deposited titanium was 50 nm. Homogeneous films were preferred over any of the layered structures.

In summary, although aluminum-based metallurgy for semiconductor interconnection technology has evolved significantly, none of the previously proposed structures or fabrication processes have been universally accepted, as evidenced by the extremely large number of studies in this technology made up to the present. One of the reasons for continuing development has been the fact that, although problems such as contact resistance, conductor resistance, electromigration, and hillock formation were recognized at an early date, approaches to solving such problems are always in the form of a trade off among different evils. With the never ending battle of increasing circuit density and its counterpart of decreasing physical dimensions, old solutions are constantly being found to be inadequate. As the limits of current technologies are reached, new limits are established.

The invention as claimed solves the problem of forming interconnecting metallurgy on semiconductor substrates and is intended to remedy the above-mentioned drawbacks.

In accordance with this invention multiple level interconnections are formed by the use of a number of interrelated and critical processing steps beginning prior to the deposition of the first interconnection level through the judicious use of chemical cleaning processes. Definition of metal layers in both the first and subsequent levels is achieved through the use of low temperature lift-off image reversal photoresist technique in combination with single pump down evaporation of a first layer of about 100 nm of substantially pure titanium followed by from about 0.5 to 1.0 µm of a second layer of aluminum-based conductor. The second layer conductor comprises aluminum containing from 0.5 to 10 percent weight copper and from 2.5 up to as much as 8 percent weight silicon. A chemical solvent process is used to remove the undesired metal overlying the lift-off resist. Next a layer of silicon nitride is deposited by a plasma enhanced CVD technique and vias where contact between first and second level interconnections are to be made are etched using a plasma process. A dielectric layer of planarizing polyimide is deposited to provide additional passivation and protection against pinholes in the nitride layer. After curing of the polyimide, oversized vias are formed in the polyimide layer using a reactive ion etching process. Prior to definition of the second level of interconnect, cleaning steps including plasma ashing followed by a chromic-phosphoric acid dip are performed. After formation of the second level lift-off photoresist mask, a second chromic-phosphoric cleaning step is performed. The second level metallurgy is evaporated in the manner described for the first level, with the requirement for silicon being dependent on the groundrules. That is, no silicon is required if contact between the second level metallurgy and silicon is not permitted by the process groundrules. After lift-off of the second level, a second polyimide layer is applied. Vias for terminal metallurgy or subsequent interconnection layers are formed by a wet develop/etch process prior to final curing of the polyimide. After final cure of the second sequential evaporation of titanium, copper, gold and tin/lead solder completes the process.

It is, therefore, an object of the present invention to establish new limits in semiconductor interconnection technology particularly in a manufacturing environment where all of the research in the technology becomes useless unless it is capable of implementation in a reliable and cost conscientious manner.

It is a particular object of the invention to provide improved multilevel interconnections for VLSI and VHSIC technologies in the sub-micron range, particularly with respect to low resistance interelectrode contacts having high reliability.

It is another object of the invention to provide low resistance, reliable ohmic contacts, which for a wiring density advantage, are permitted to be only partially covered by interconnection metallurgy.

It is another object to provide improved multilevel interconnections suitable for fabrication in a high volume, mass production integrated circuit manufacturing environment.

The foregoing objects, additional features, and advantages of the invention will be apparent from the following and more particular description of a preferred embodiment of the invention, as illustrated in the accompanying drawings.

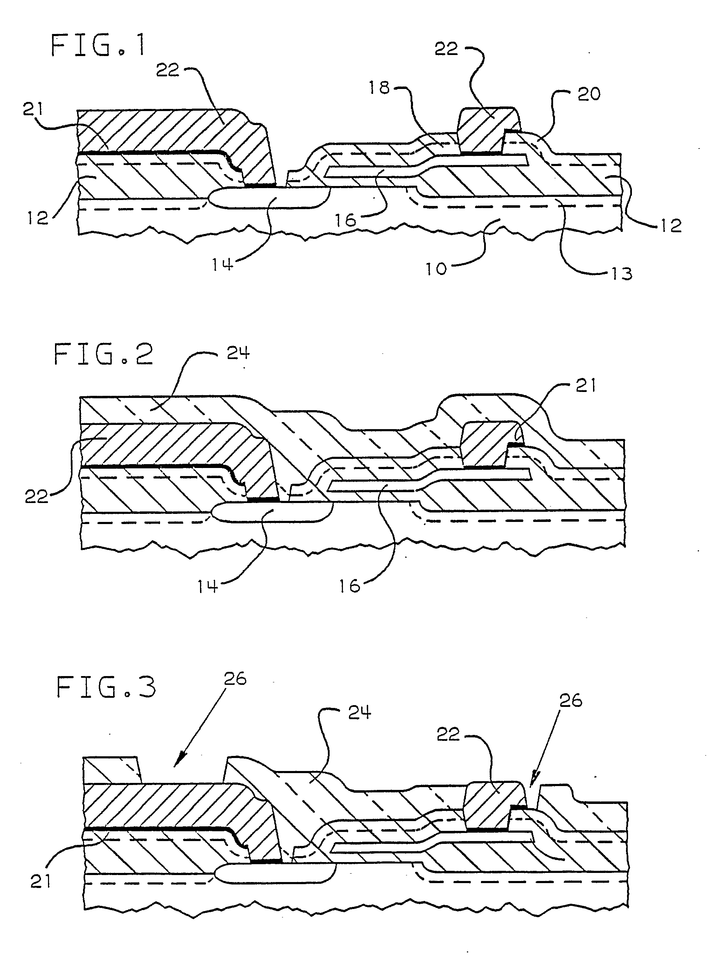

FIGS. 1-8 are sectional views of a semiconductor structure showing various stages of the process and structure of the invention, beginning with the first level of metallurgy through the final terminal metallurgy.

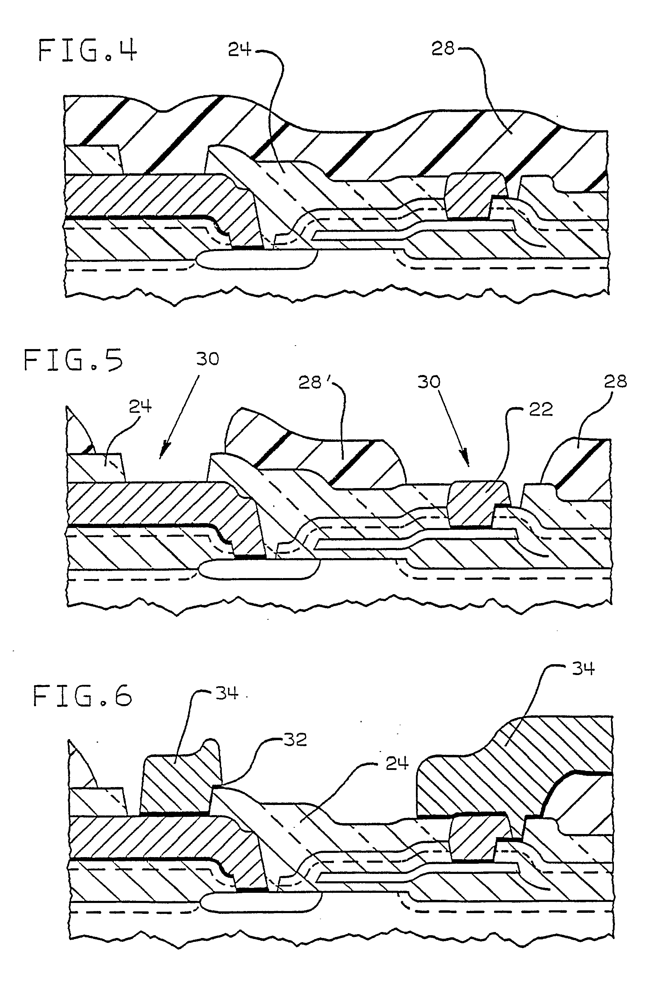

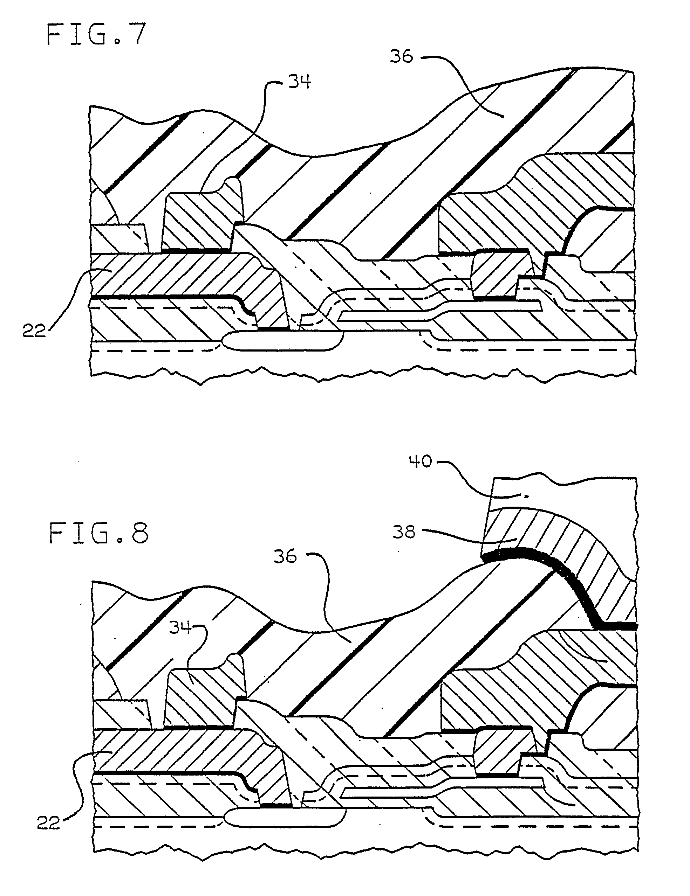

FIG. 1 is a cross-sectional view of a typical semiconductor substrate on which the metallurgy of the invention can be formed. The substrate can be any of a number of types which contain previously formed diffusion regions corresponding to semiconductor device elements separated by dielectric regions. The specific type of semiconductor device shown is that of the MOS technology, but may also be bipolar or so-called biFET technology. The upper surface of a semiconductor wafer 10 can be of N-type or P-type and may comprise an epitaxial layer or a homogeneously doped bulk semiconductor. A field oxide on the surface, shown as semi-recessed oxide regions 12, serves to isolate active devices on the surface of 10. A channel stopper diffused region 13 is usually formed under oxide 12 to further aid in isolating active device regions. Active device diffused region 14 formed in the surface may be of the same or opposite conductivity type as wafer 10 and provides a point of access to an overlying conductor by an ohmic contact. Within the structure illustrated in FIGS. 1-8 there are actually five different levels of interconnection shown. The first is that of the diffusions 14 which can be used to connect various device regions within the semiconductor substrate itself. The second is usually formed of polysilicon or a refractory metal layer 16, which may or may not make contact to diffused regions, and is usually isolated from adjacent conductive layers by a glassy inorganic layer such as silicon dioxide. Because the passivation process for the second layer usually requires a relatively high temperature annealing step, low melting point metals such as aluminum cannot be used. The third interconnection level is preferred to be aluminum-based and is shown in all of the figures. This level is used to make the interconnections to the substrate and to the second layer and thus is subject to aluminum penetration addressed by Kuiper, above. The fourth level, shown in FIGS. 6-8, is also usually aluminum-based and is used to interconnect portions of the third level. A significant improvement in wiring density can be achieved if full coverage of contact vias is not required. Note, as shown in the drawings, that partially covered contacts formed by a lift-off technique are permitted at the third and fourth interconnection levels. In many applications it is desirable to define lines in the third and fourth levels to run in predominantly orthogonal directions, respectively, in order to obtain the maximum wireability. The fifth and final level is shown only in FIG. 8 and consists of various metallurgies useful for making connections between the semiconductor device and its packaging leads, not shown.

The formation and passivation of the first and second levels of interconnection are not particularly significant to the invention and any of a number of prior art processes can be used. Assuming, for purposes of example, that the N-well CMOS process described in US-A-4 470 191 is used, surface region 10 represents a portion of a lightly doped epitaxial layer formed on a P+ silicon substrate. Diffused region 14 would be of N+ conductivity and channel stopper 13 would be of P type. Second level 16 can be formed by a polysilicon or polycide layer which is passivated by a silicon dioxide layer 18 over which is applied a phosphorous doped or boro-phosphorous doped oxide layer 20. Via holes to diffused regions 14 and to second level layer 16 are formed by a photolithographic process in combination with a plasma etching process. Following the stripping of the photoresist in an oxygen plasma, contact holes are cleaned in a hot 40:1 sulfuric acid/hydrogen peroxide bath.

In accordance with the invention, the third level of interconnect and first level of aluminum-based conductors are formed by the following steps. The substrate is first cleaned in a hot 4:1 sulfuric acid/hydrogen peroxide bath followed by a deionized water rinse and air dried. Next, the substrate is exposed to an ammonium fluoride buffered hydrofluric acid bath, annealing in forming gas comprising about 5 percent hydrogen in nitrogen and again cleaned in 4:1 sulfuric acid/hydrogen peroxide. This process sequence provides for the removal of polymeric residuals, ionic contaminants and radiation damage resulting from the dry etch of the contact vias to the first and second interconnection levels. The surface of the substrate is sensitized by exposure to vapors of hexamethyldisilizane (HMDS), taught in US-A-3 549 368, containing 1,1,2-trichlorotrifluoroethane. A specially formulated lift-off positive acting photoresist formed from a soluble phenolic resin and a sensitizer comprising 4,8-bis(6-diazo-5-oxo-5,6-dihydro naphthalene sulfonyl oxymethyl)tricyclo [5.2.1.0] decane, as described in US-A-4 397 937, containing 1 percent imidazole and 0.6 percent Oraset 8GF, a methine dye, is applied to a thickness of about 1.8 μm. The photoresist is exposed by a positive image mask to define the first aluminum-based interconnect patterns. Via holes necessary to provide desired contacts are on the order of 1X1 μm. Partial contact coverage of as little as 25% of these contacts have been found to be acceptable from a resistance and reliability point of view. In accordance with the image reversal process generally described in US-A-4 104 070, imagewise exposure is followed by a bake at about 100 degrees C for about 20 minutes in order to decarboxylate the photodecomposition products in the exposed regions of the resist rendering exposed baked regions less soluble than regions not exposed. This is followed by a blanket exposure to solubilize the previously unexposed resist so that it can be easily removed in a developer. The resist is then developed in 0.1 molar sodium metasilicate solution which removes only the initially unexposed regions of the photoresist leaving the photoresist everywhere except where the metal lines are to be formed.

Prior to actual deposition of metal, the photoresist covered substrate is cleaned with an RF plasma process capable of removing several hundred angstroms of resist followed by a buffered hydrofluric acid bath. The substrates are then placed in a RF powered evaporation chamber. Metal evaporation sources include titanium on a tungsten filament, aluminum containing 0.5 to 10 percent copper in a boron nitride evaporation crucible and silicon in a carbon crucible. Because the evaporation sources cannot all occupy a position providing a normal angle of incidence, the Al/Cu source is positioned to provide a normal angle of incidence and the others are positioned as close as possible thereto. Positioning of the titanium source is preferred to be placed at an angle of no more than 10 degrees off of the normal. After a suitable vacuum is achieved, current is passed through the titanium filament to cause selective evaporation of about 70 to 130 nm of titanium. Next, without breaking the vacuum, the titanium filament is de-energized and RF coils are energized to begin sequential evaporation of the Al/Cu and Si, at the respective rates of 3.0 to 4.0 and more than 0.2 nm/sec. After the total thickness reaches between 570 and 830 nm, the evaporation process is terminated. The resulting conductor, as shown in FIG. 1, is a thin layer of titanium 21 covered by a thicker layer of aluminum 22 doped with copper and having an upper layer of silicon. Due to the above referenced offset of the titanium source in combination with the physical structure of the lift-off photoresist structure, the titanium layer is offset slightly (shown as being to the right in FIG. 1) with respect to the aluminum-based layer. Although the use of a titanium underlayer is known to provide a metallurgical barrier preventing aluminum from contacting the silicon substrate and thus eliminating the requirement of presaturating the aluminum layer with silicon, in the case of lift-off deposition the offset effect increases the possibility of aluminum/silicon contact to the extent that silicon is required to be present in the first aluminum layer. Thus, the presence of silicon in the aluminum is necessary to prevent aluminum penetration during high temperature annealing of the metallurgy. When the prior art percentage of about 1 percent silicon is present in the Al-Cu/Ti layers deposited as described, we found that serious aluminum penetration persisted. Increasing the as deposited percentage of silicon to 2 percent was also found to provide no improvement in aluminum penetration. Only when the percentage of silicon was increased to the range of 2.5 to 3.5 percent, well beyond the 0.3 percent solid solubility of silicon in aluminum, at the maximum post-metal anneal temperatures of 400 degrees C, was the aluminum penetration eliminated. Although the reason for the need for such high levels of silicon is unknown, we believe that because of the presence of titanium under the entire layer of aluminum-copper a substantial quantity of silicon is bound in titanium intermetallic compounds formed during deposition leaving a much smaller amount of silicon to satisfy the silicon solubility requirement necessary to prevent aluminum penetration due to an insufficient amount of silicon and at the same time prevent the formation of a high resistivity epitaxial layer of silicon due to too much silicon. As the relative thickness of the aluminum-based layer decreases, the required percentage of silicon increases. For example, for an aluminum-based layer of about 200 nm approximately 8 percent silicon is expected to be required. The 0.5 to 10 percent copper present in the deposited layer of aluminum is consistent with prior art teachings to provide adequate protection against electromigration and to reduce hillock formation.

Following deposition of the metal layers 21 and 22, the lift-off photoresist and overlying metal are removed by dipping in n-methyl 2-pyrrolidone (NMP). The substrates are then annealed in forming gas at 400 degrees C for about 20 minutes.

Referring to FIG. 2, a double level dielectric passivation is provided as in generally described US-A-4 423 547. After cleaning in isopropyl alcohol, a silicon nitride layer 24 is deposited by a plasma CVD process using a mixture of about 250 to 450 cc/min silane and 3200 to 3800 cc/min ammonia to provide a thickness of between 240 and 360 nm over the entire substrate. In order to reduce the step height between the first and second aluminum-based metallurgy, via holes are etched prior to deposition of the second passivation layer. After HMDS vapor exposure, photoresist comprising m-cresol formaldehyde resin and a 5-substituted diazonaphthoquinone sensitizer is applied, baked and exposed to define desired via holes necessary for contact between the first and second aluminum-based levels. The resist is developed in 0.1 normal potassium hydroxide. As shown in FIG. 3, vias 26 are etched through the nitride using a reactive ion etch/plasma etch process to provide a combination of isotropic and anisotropic etching similar to that described in US-A-4 457 820. Specifically, the process includes an organic descum in oxygen followed by isotropic etch in CF4 and oxygen at a pressure of about 0,2 mbar (150 mtorr) at 470 watts applied power and then an anisotropic etch in CF4 and oxygen at a pressure of about 0,04 mbar (30 mtorr) at 600 watts. The substrate is then dipped into a hot chromic-phosphoric acid bath comprising about 0.2 gram of chromic trioxide per 1 ml concentrated phosphoric acid and 1 ml water at a temperature of between 64 and 70 degrees C for 2 minutes in order to remove inorganic residues remaining after the plasma process. Next, the substrate is exposed to an oxygen plasma at a pressure of about 1 torr for about 40 minutes to remove organic residues. Following these cleaning steps, the remaining photoresist is stripped in a bath of NMP. Finally, the substrate· is again exposed to an oxygen plasma, as described above.

Following the definition of via holes 26 in the nitride layer 24, as shown in FIG. 4, a second passivation layer 28, comprising a planarizing polyamide alkyl ester, such as described in US-A-4 612 210, is applied over a sensitizing layer of gamma-amino propyl triethoxy silane, as described in US-A-3 455 725. A three stage thermal cure is performed. The first is performed at about 140 degrees C in order to drive off solvents in the polyamide precursor. The second intermediate cure is performed at about 195 degrees C for 30 minutes. The final cure is performed at about 350 degrees C for about 20 minutes. The thickness of the polyamide layer is preferred to be between about 750 and 950 nm.

Referring now to FIG. 5, oversized via holes 30 are formed by the following process. After application of about 2.2 μm of a photoresist such as Shipley AZ 4210, the resist is dried and exposed to define the location of desired via holes in the polyamide layer 28. The exposed resist is developed in 0.18 molar potassium hydroxide. Following development, any residual hydroxide remaining on the photoresist and exposed polyamide layer 28 is neutralized by dipping in a solution of 0.5 percent acetic acid. The substrate is then blanket exposed to aid in the subsequent solvent removal of the photoresist and then baked for about 15 minutes at 130 degrees C in order to cause the sidewalls of the vias in the developed resist to reflow, reducing the angle which the sidewalls of the photoresist make with respect to the underlying polyamide layer. Vias 30 are etched in a RIE process using oxygen plasma at a pressure of about 0,166 mbar (125 mtorr) and a lower powered plate at about 500 watts. Because the RIE process is not particularly selective between photoresist and polyamide, etching is terminated using an end point detector. At the completion of etching, the remaining photoresist is removed in an n-butyl acetate bath followed by dipping in isopropyl alcohol.

Because of the criticality of obtaining ohmic contact between the first and second aluminum-based layers, important cleaning or surface preparation steps have been found to be required. Residual traces of photoresist are removed by a plasma ashing in oxygen at a pressure of about (1,33 mbar) 1 torr for about 20 minutes. The substrate is again cleaned in hot chromic-phosphoric acid to remove any inorganic contaminants which may be present on the substrate, particularly in the via holes. As with the first aluminum-based layer, the processing steps include application of HMDS followed by photoresist. The preferred photoresist for the second level metal lift-off process is described in US-A-4 397 937 and is a positive resist formed from phenolic resin and a sensitizer which is a diester of a 1-oxo-2-diazo naphthalene sulfonic acid and an unsymmetrical primary or secondary aliphatic diol containing about 1.0 percent imidazole and having a thickness of about 2.4 μm. As with the first metal lift-off resist, the resist is first exposed, baked and then blanket exposed, developed by a sodium metasilicate developer, and neutralized by acetic acid by the processes previously described. Following development, the substrate is once again exposed to an oxygen plasma followed by hot chromic-phosphoric acid cleaning steps. Within six hours after the last cleaning step, the second level interconnection layer, including a first layer of titanium 32 followed by a second thicker layer of aluminum-based metallurgy 34, is deposited by evaporation. With the following differences, the deposition is identical to that used for the first level interconnection layer. At this level, inclusion of silicon in the metallurgy is optional depending upon whether the metallurgy is permitted by the process groundrules to make contact to underlying layers containing a sufficient amount of silicon to potentially cause aluminum penetration.

Following deposition of the second level of aluminum-based metallurgy, the lift-off photoresist is removed in a bath of NMP and the substrate is annealed in nitrogen for about 20 minutes at about 350 degrees C. The resulting second level of interconnection layer, as shown in FIG.6, consists of a first layer 32 of 70 to 130 nm titanium overlaid with a second layer 34 of about 1000 to 1200 nm aluminum doped with from 0.5 to 10 percent copper.

As in the US-A-4 423 547, the final passivation layer is formed of polyimide. Prior to formation of the polyimide layer, the substrate is cleaned in baths of n-butyl acetate and isopropyl alcohol. This is followed by a bake at 125-135 degrees C and another oxygen plasma ashing process. After sensitizing the surface of the substrate with gamma-amino propyl triethoxy silane, I.E. duPont polyimide precursor, P.I. 5878, is applied to a thickness of about 5.6 μm and baked at about 120 degrees C for about 15 minutes in order to remove solvent and to partially imidize the polymer. As shown in Fig. 7, a somewhat planarized layer of polyimide 36 is formed over the entire substrate. Next, a photoresist such as previously used AZ 4210 is applied, dried and exposed to define via holes between the second level aluminum-based metal and metallurgy of choice used to make connections to the packaging leads.

The photoresist is developed and the polyimide is etched in a single process step using a 5 percent solution of tetramethyl ammonium hydroxide. As previously described, the residual alkaline developer is neutralized in 0.5 percent acetic acid. Next, the photoresist is selective striped from the partially cured polyimide layer by diping in n-butyl acetate and isopropyl alcohol. The finally defined polyimide layer 36 is cured in a two stage bake process. The first stage is at about 185 to 205 degrees C for about 20 minutes in air and the second at about 345 to 355 degrees C for about 20 minutes in nitrogen.

The semiconductor device is completed, as shown in Fig. 8, by deposition of the terminal metallurgy 38 applied by evaporation in a single chamber. As with the preceding metal levels, titanium is used as the initial layer, followed by a mixture of titanium and copper, a layer of copper, a layer of gold, and finally a lead-tin solder pad 40. The evaporation sources are again resistance heated. Prior to placing the substrate within the evaporation chamber, the substrate is exposed to an oxygen plasma at a pressure of about 1,33 mbar (1 torr) for about 20 minutes. Next, the substrate is dipped in a hot chromic-phosphoric acid bath for about two minutes. Then substrates are positioned with the evaporation chamber with a molybdenum metal mask placed on the substrate to screen the surface except where the previously defined via holes have been formed. After pump down, the substrate is heated to a temperature of between 225 to 275 degrees C. Evaporation proceeds by depositing about 100 to 190 nm titanium, 70 to 220 nm of titanium-copper (with the ratio of copper to titanium about 3:1), 900 to 1300 nm copper and 80 to 180 nm gold to provide a total Ti-Cu-Au thickness of about 1475 nm. Next lead containing about 3 percent tin is deposited to a thickness of about 0.13 mm. Following deposition of the terminal metals, the molybdenum mask is removed and the substrate is heated to about 353 degrees C to cause the solder to reflow forming a smooth ball-like pad suitable for subsequent solder bonding to packaging leads.

## Claims

1. The method of providing multilevel metallurgical interconnections to a silicon semiconductor substrate containing semiconductor device structures including an upper surface comprising a passivation layer and previously defined contact vias to which contact is to be made, comprising the steps of:
selectively forming a first level interconnection layer, including deposition by evaporation in a continuous sequence on the upper surface of the passivation layer and at least portions of the contact vias, a first layer of about 100 nanometers of titanium followed by a substantially thicker metal layer consisting substantially of aluminum containing between 0.5 to 10 weight percent copper and 2.5 to 8.0 weight percent silicon;
heating the substrate to anneal the evaporated layers;
forming a multilayer passivation layer over the evaporated layer comprising at least a top layer of an organic polymer, the multilayer passivation layer having contact via holes formed therein exposing at least portions of the first interconnection layer; and
selectively forming a second level interconnection layer, including deposition by evaporation in a continuous sequence on the upper surface of the multilevel passivation layer and in at least a portion of the contact via holes, a first thin layer of titanium followed by a thicker metal layer having a composition different from the thicker metal layer of the first level interconnection layer.

2. The method of claim 1 wherein the forming of the first level interconnection layer is achieved by the steps of:
providing a removable masking layer on the upper surface of the said passivation layer defining the first level interconnection pattern;
evaporating the titanium and thicker metal layer; and
removing the masking layer and overlying metal layers.

3. The methods of claims 1 or 2 wherein the multilayer passivation layer is formed by the steps of:
depositing a layer of silicon nitride;
etching contact via holes in the silicon nitride layer to expose portions of the first level interconnection layer;
depositing a polymer-forming layer selected from the group consisting of polyimide and polyamide forming reactants;
partially curing the polymer-forming layer to at least partially polymerize the layer; and
etching contact via holes in the polymerized layer to re-expose said portions of the first level interconnection layer.

4. The method of one of the preceding claims wherein the forming of the second level interconnection layer is achieved by by the steps of:

providing a removable masking layer on the upper surface of the said multilayer passivation layer defining the second level interconnection pattern;

evaporating the titanium and thicker metal layer; and

removing the masking layer and overlying metal layers.

5. The method of one of the preceding claims wherein the thicker metal layer of the second level interconnection layer comprises substantially aluminum containing between 3.5 and 10 percent by weight copper.

6. The method of one of the preceding claims further including the additional steps of:

depositing a polymer-forming layer selected from the group consisting of polyimide and polyamide forming reactants on the second interconnection layer;

at least partially curing the polymer-forming layer to at least partially polymerize the layer; and

etching contact via holes in the at least partially polymerized layer to expose portions of the second level interconnection layer;

selectively forming a third level interconnection layer, including deposition by evaporation in a continuous sequence on the upper surface of the last said polymer-forming layer and the contact via holes, a first thin layer of titanium followed by a thicker metal layer having a composition different from the thicker metal layer of both the first and second level interconnection layers.

7. The method of claim 6 wherein the third level interconnection layer is the last level of interconnection provided to the substrate.

8. The method of one of the preceding claims wherein, after forming the multilayer passivation layer, the step of forming of the second level interconnection layer is preceded by the sequential steps of:

exposing the substrate to a low pressure oxygen plasma; and

exposing the substrate to a hot acid reagent comprising concentrated aqueous phosphoric acid and chromium trioxide at a temperature in excess of 50 degrees C for about 4 minutes.

9. The method of one of the preceding claims wherein, after forming the multilayer passivation layer, the second level interconnection layer is formed by the steps of:

exposing the substrate to a low pressure oxygen plasma for about 20 minutes;

exposing the substrate to a hot acid reagent comprising concentrated aqueous phosphoric acid and chromium trioxide at a temperature in excess of 50 degrees C for about 2 minutes;

providing a removable masking layer on the upper surface of the said multilayer passivation layer to define the second level interconnection pattern;

exposing the substrate to a low pressure oxygen plasma for about 4 minutes;

exposing the substrate to a hot acid reagent comprising concentrated aqueous phosphoric acid and chromium trioxide at a temperature in excess of 50 degrees C for about 2 minutes;

evaporating the titanium and thicker metal layers of the second level interconnection layer; and

removing the masking layer and overlying metal layers.

10. The method of claim 9 wherein the hot acid reagent consists substantially of a mixture of 1 gram of chromium trioxide to 1 milliliter of concentrated phosphoric acid in 50 milliliters of water at a temperature of between 60 and 70 degrees C.

FIG.1

FIG.2

FIG.3

FIG.4

FIG.5

FIG.6

FIG.7

FIG.8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | 1984 PROCEEDINGS, IEEE VLSI MULTILEVEL INTERCONNECTION CONFERENCE, New Orleans, 21st-22nd June 1984, pages 1-21, IEEE, New York, US; A.N. SAXENA: "VLSI multilevel metallizations: Present status and future requirements" * Table 1 * | 1,5,7 | H 01 L 21/60<br>H 01 L 21/90<br>H 01 L 23/52 |
| A | EP-A-0 239 756 (IBM) * Column 7, lines 21-31 * | 1,2,4,6 ,9 | |
| A,D | EP-A-0 066 069 (IBM) * Claim 1; page 11, lines 4-9 * & US-A-4 423 547 (Cat. A) | 1,3,6 | |
| A | PROCEEDINGS, IEEE 32nd ELECTRONIC COMPONENTS CONFERENCE, San Diego, 10th-12th May 1982, pages 309-313, IEEE, New York, US; D.A. GROSE et al.: "A simple evaporation process for producing improved interlevel via resistance" * Page 309, column 2, line 4 - page 310, column 1, line 15 * | 1,8,9 | |
| | | | TECHNICAL FIELDS SEARCHED (Int. Cl.4) |
| | | | H 01 L |

The present search report has been drawn up for all claims

| Place of search | Date of completion of the search | Examiner |
|---|---|---|
| THE HAGUE | 08-06-1989 | PHEASANT N.J. |

EPO FORM 1503 03.82 (P0401)